# EUROPEAN PATENT SPECIFICATION

(11) **EP 4 404 417 B1**
(45) Date of publication and mention of the grant of the patent: **31.12.2025**
(21) Application number: 22883918.9
(22) Date of filing: 17.10.2022
(51) Int. Cl.: H02J 7/00, H01M 10/42

(54) **BATTERY CONTROL SYSTEM AND METHOD FOR MANAGING BATTERY STATE**
BATTERIESTEUERUNGSSYSTEM UND VERFAHREN ZUR VERWALTUNG DES BATTERIEZUSTANDS
SYSTEME DE COMMANDE DE BATTERIE ET PROCEDE DE GESTION DE L'ETAT DE LA BATTERIE

(30) Priority: 18.10.2021 KR 20210138633
(43) Date of publication of application: 24.07.2024
(73) Proprietor: LG Energy Solution, Ltd., Seoul 07335 (KR)
(72) Inventor: CHOI, Moon Gyu, Daejeon 34122 (KR); KIM, Ki Hun, Daejeon 34122 (KR); PARK, Jun Oh, Daejeon 34122 (KR)
(74) Representative: Plasseraud IP
(86) International application number: PCT/KR2022/015707
(87) International publication number: WO 2023/068695

(56) References cited:
- EP-A1- 2 348 599
- JP-A- 2011 030 399
- KR-A- 20110 087 565
- KR-A- 20160 032 315
- KR-A- 20190 049 997
- US-A1- 2017 021 738
- US-A1- 2017 021 738
- US-A1- 2019 237 816

## Description

### [TECHNICAL FIELD]

Embodiments disclosed herein relate to a battery control system and method for managing a battery state.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles.

Further background art is disclosed in EP 2348599 A1; US 2019/237816 A1; and US 2017/021738 A1.

### [DISCLOSURE]

### [TECHNICAL PROBLEM]

For a battery-mounted device, e.g., a vehicle, a battery control system turns off a relay to prevent a user from using a battery arbitrarily when the device is turned off. However, when the relay is turned off in a high state-of-charge (SoC) state of the battery, a battery cell may ignite due to an external factor such as collision or an internal factor such as short-circuit.

### [TECHNICAL SOLUTION]

In order to overcome the above problem, an operating method and a battery control system are provided as defined by the independent claims 1 and 4.

### [ADVANTAGEOUS EFFECTS]

A battery control system according to an embodiment disclosed herein may reduce the risk of ignition that may occur while an operation of an electronic device having mounted thereon a battery is off.

### [DESCRIPTION OF DRAWINGS]

FIG. 1 is a block diagram of a general battery pack including a battery management apparatus according to various embodiments.
FIG. 2 is a block diagram showing a configuration of a battery control system according to various embodiments.
FIG. 3 is a signal flowchart between a master battery management system and a battery management system according to various embodiments.
FIG. 4 is an operation flowchart of consuming battery energy, according to various embodiments.
FIG. 5 is an operation flowchart of consuming battery energy, according to various embodiments.
FIG. 6 is an operation flowchart of consuming battery energy, according to various embodiments.
FIG. 7 is an operation flowchart of consuming battery energy, according to various embodiments.
FIG. 8 is a block diagram showing a computing system that performs a battery management method according to various embodiments.

### [MODE FOR INVENTION]

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1^{st}, "2^{nd}", "first", "second", or the like may modify various components regardless of importance, and do not limit the components. For example, a first component may be named as a second component without departing from the right scope of an embodiment disclosed herein, and similarly, the second component may be named as the first component.

Terms used in the present document are used for only describing a specific exemplary embodiment of the disclosure and may not have an intention to limit the scope of other exemplary embodiments of the disclosure. It is to be understood that the singular forms include plural references unless the context clearly dictates otherwise.

All terms including technical and scientific terms used herein have the same meaning as commonly understood by one of ordinary skill in the art to which the embodiments disclosed herein belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments disclosed herein.

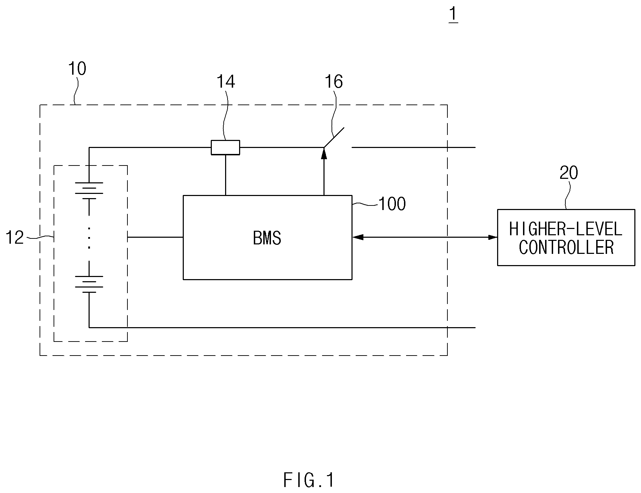

FIG. 1 is a block diagram of a general battery pack including a battery management apparatus according to various embodiments.

More specifically, FIG. 1 schematically shows a battery control system 1 including a battery pack 10 and a higher-level controller 20 included in a higher-level system according to an embodiment disclosed herein.

As shown in FIG. 1, the battery pack 10 may include a plurality of battery modules 12, a sensor 14, a switching unit 16, and a battery management system 100. The battery pack 10 may include the battery module 12, the sensor 14, the switching unit 16, and the BMS 100 provided in plural.

The plurality of battery modules 12 may include at least one chargeable/dischargeable battery cells. In this case, the plurality of battery modules 12 may be connected in series or in parallel.

The sensor 14 may detect current flowing in the battery pack 10. In this case, a detected signal may be transmitted to the battery management system 100.

The switching unit 16 may be connected in series to a (+) terminal side or a (-) terminal side of the battery module 12 to control the charging/discharging current flow of the battery module 12. For example, the switching unit 16 may use at least one relay, a magnetic contactor, etc., according to the specifications of the battery pack 10.

The battery management system 100 may monitor the voltage, current, temperature, etc., of the battery pack 10 to perform control and management to prevent overcharging and overdischarging, etc., and may include, for example, an RBMS.

The battery management system 100, which is an interface for receiving measurement values of the above-described various parameter values, may include a plurality of terminals and a circuit, etc., connected thereto to process input values. The battery management system 100 may control on/off of the switching unit 16, e.g., a relay, a contactor, etc., and may be connected to the battery module 12 to monitor the state of each battery module 12.

The higher-level controller 20 may transmit a control signal for controlling the battery module 12 to the battery management system 100. Thus, the battery management system 100 may be controlled in terms of an operation thereof based on a signal applied from the higher-level controller 20. Also, the battery module 12 may be a component included in an energy storage system (ESS). In this case, the higher-level controller 20 may be a controller (BBMS) of a battery bank including the plurality of packs 10 or an ESS controller for controlling the entire ESS including a plurality of banks. However, the battery pack 10 is not limited to such a purpose.

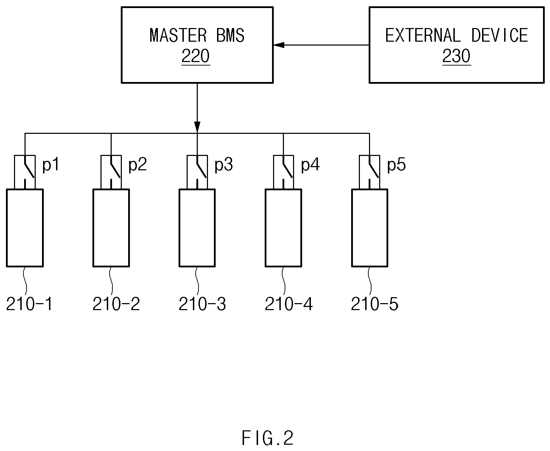

FIG. 2 is a block diagram showing a configuration of a battery control system according to various embodiments.

Referring to FIG. 2, a battery control system 1 may include a plurality of battery packs (e.g., 210-1 to 210-5), relays p1 to p5 for connection of the plurality of respective battery packs, and a master battery management system 220. The number of plural battery packs and relays is not limited to an example shown in FIG. 2. According to an embodiment, the battery control system 1 may further include a current sensor for measurement of electric current. In this case, there may be a current sensor capable of measuring an electric current for each of the plurality of battery packs as well as the current sensor connected to the master battery management system 220. Although not shown in FIG. 2, each of the plurality of battery packs may include components shown in FIG. 1.

The battery control system 1 may determine operation ON/OFF of an external device 230 based on a signal received from the external device 230. The external device 230 may be a component used for driving the vehicle, e.g., an inverter or a motor of the vehicle. In this case, the master battery management system 220 may detect start ON/OFF of the vehicle through the external device 230. When the vehicle is start ON, the master battery management system 220 may connect a plurality of battery packs through the relays p1 to p5 to supply power to the external device 230. When the vehicle is start OFF, the master battery management system 220 may disconnect the relays p1 to p5 to prevent the user from using the battery pack arbitrarily.

A battery cell included in each of the plurality of battery packs 210-1 to 210-5 may ignite due to a factor such as collision or short-circuit even in an OFF state of the relay, such that the battery control system 1 according to embodiments may lower an energy density of some packs based on a pack state of each of the plurality of battery packs 210-1 to 210-5 in an operation OFF state of the external device 230. In this way, the battery control system 1 may reduce the risk of ignition that may occur in the start OFF state of the vehicle.

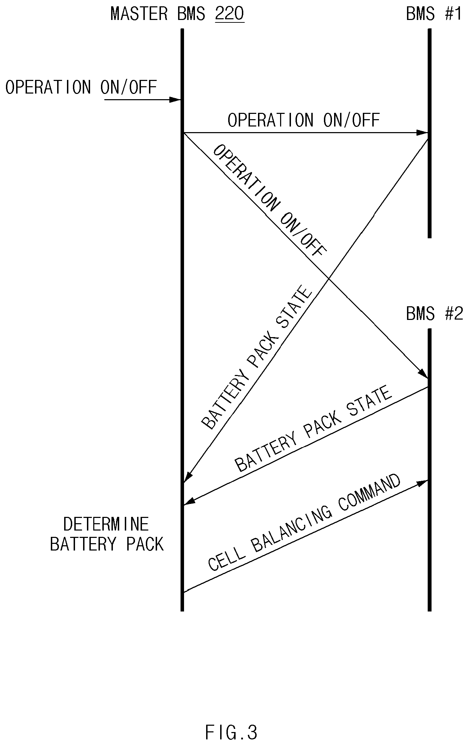

FIG. 3 is a signal flowchart between a master battery management system and a battery management system according to various embodiments. Each of battery management systems #1 and #2 shown in FIG. 2 may perform a function of the battery management system 100 shown in FIG. 1, and each of the battery management systems #1 and #2 may be included in some of the plurality of battery packs 210-1 to 210-5 shown in FIG. 2.

Referring to FIG. 3, the master battery management system 220 may transmit an operation ON/OFF signal to the battery management systems #1 and #2 based on a signal received from the external device 230 (e.g., an operation ON/OFF signal).

Each of the battery management systems #1 and #2 may transmit battery pack state information to the master battery management system 220. The pack state information may indicate, for example, a remaining SoC of battery cells included in each battery pack. In another example, the pack state information may indicate battery diagnosis history information of each battery pack. The battery diagnosis history information may include, for example, information related to battery safety diagnosis such as over-voltage (OV), under-voltage (UV), over-current (OC), or over-temperature (OT).

The master battery management system 220 may determine a battery pack for connection of a relay and a battery pack for reduction of an energy density, based on the received battery pack state information. For example, the master battery management system 220 may determine, as a battery pack for which an energy density needs to be lowered, a battery pack including one or more cells having the remaining SoC exceeding a threshold value (e.g., 10%) in an operation OFF state of the external device 230. In another example, the master battery management system 220 may determine, as the battery pack for which the energy density needs to be lowered, a battery pack having a history of detected battery abnormality, e.g., a history of detection of at least one of OV, UV, OC, or OT. On the other hand, the master battery management system 220 may determine, as an available battery pack, a battery pack having the remaining SoC less than or equal to a threshold value and having no history of detected battery abnormality. The available pack may mean a pack that provides power through relay connection in the future operation of the external device 230 (e.g., a vehicle).

The master battery management system 220 may instruct the battery management system (e.g., #2) of the battery pack for which the energy density needs to be lowered to perform cell balancing. The battery management system #2 may forcedly lower the energy of the battery cell having the remaining SoC exceeding the threshold value through cell balancing.

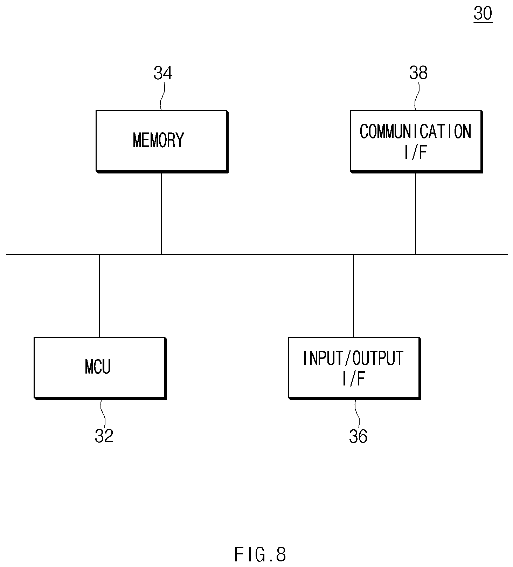

In addition to an example shown in FIG. 3, the battery management system #2 may perform another operation to lower the energy density of the battery cell. For example, the battery management system #2 may set a phase-locked loop (PLL) frequency of an MCU (e.g., 32 of FIG. 8) to a maximum value. When the frequency of the MCU PLL is set to the maximum value, the current consumption of the MCU may increase, thus increasing the amount of energy consumption of the battery cell. For example, when the PLL frequency changes from 30 MHz to 120 MHz, the current consumption of the MCU may increase four times. In another example, the battery management system #2 may change an operation mode of an integrated circuit (IC) included in the battery pack from a low consumption mode to a high consumption mode. For example, an IC for CAN communication in a battery pack conventionally operates in the low consumption mode to prevent power consumption, but the battery management system #2 may change the operation mode of the IC for CAN communication to the high consumption mode to increase energy consumption of the battery cell.

According to an embodiment, whether the battery pack is available based on the remaining SoC or the battery diagnosis history may be determined based on the battery management system #1 or #2 rather than the master battery management system 220. In this case, the battery management system #1 or #2 may notify the master battery management system 220 of the determined result or perform an operation for lowering the energy density without a command of the master battery management system 220. When the battery pack is not available, the battery management system (e.g., #2) may not transmit a signal indicating availability and the master battery management system 220 may exclude the battery pack having not received the signal indicating availability from parallel connection.

In an embodiment, the battery management system #2 of the battery pack having the remaining SoC exceeding the threshold value or having the history of detected battery abnormality may operate in a sleep mode to prevent use of the battery pack.

In an embodiment, the master battery management system 220 may not perform the operation of forcedly lowering energy for safety when the battery control system 1 is in a charge or discharge mode.

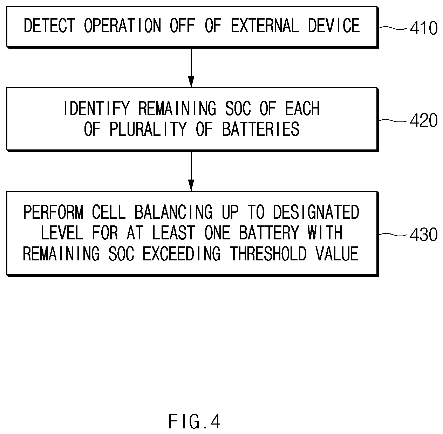

FIGS. 4 to 7 are operation flowcharts of consuming battery energy, according to various embodiments. In the following description, operations included in the operation flowchart may be implemented by the battery control system 1 or a component thereof (e.g., the master battery management system 220 or the battery management system 100).

Referring to FIG. 4, in operation 410, the battery control system 1 may detect an operation OFF of the external device 230 (e.g., vehicle start OFF).

In operation 420, the battery control system 1 may identify the remaining SoC of each of a plurality of batteries. Herein, a 'battery' may include not only a 'battery pack', but also a detailed unit (e.g., a battery cell) of the battery pack. For example, a battery management system of each of the plurality of battery packs (e.g., 210-1 to 210-5) may identify the remaining SoC for each battery cell. In this case, the battery management system may notify the master battery management system 220 of the identified remaining SoC information.

In operation 430, the battery control system 1 may perform cell balancing up to a designated level for at least one battery with the remaining SoC exceeding a threshold value. For example, when there is at least one cell exceeding with the remaining SoC exceeding 10 % in the battery pack, the battery management system of the battery pack may perform cell balancing until the SoC of the cell becomes 10 % or less.

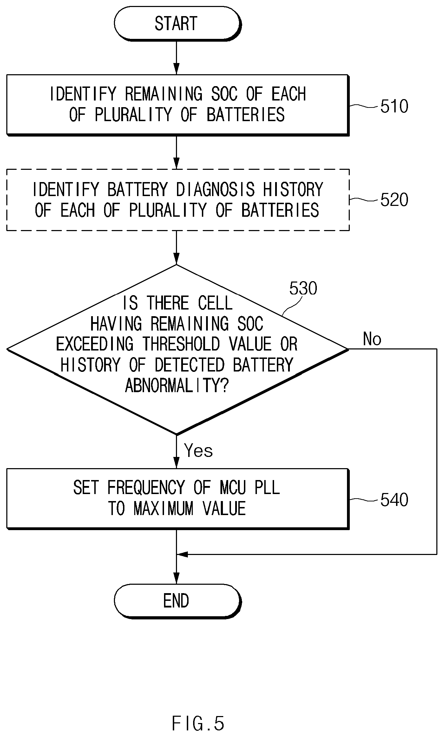

FIGS. 5 to 7 are operation flowcharts of another embodiment for lowering an energy density of a battery. Operations shown in FIGS. 5 to 7 may be performed after operation 410 of FIG. 4.

Referring to FIG. 5, in operation 510, the battery control system 1 may identify the remaining SoC of each of a plurality of batteries (e.g., operation 420 of FIG. 4). In addition, in operation 520, the battery control system 1 may identify a battery diagnosis history of each of the plurality of batteries. The battery diagnosis history may be related to battery safety such as OV, UV, OC, or OT. In this case, an order of implementation of operations 510 and 520 is not limited to an example shown in FIG. 5.

In operation 530, the battery control system 1 may identify whether there is a battery having the remaining SoC exceeding the threshold value or the history of detected battery abnormality among the plurality of batteries. When the remaining SoC is less than or equal to the threshold value and there is no the history of detected battery abnormality for every battery, then the battery control system 1 may terminate an algorithm.

When there is a battery having the remaining SoC exceeding the threshold value or having the history of detected battery abnormality, the battery control system 1 may set the frequency of the MCU PLL corresponding to the battery to a maximum value in operation 540.

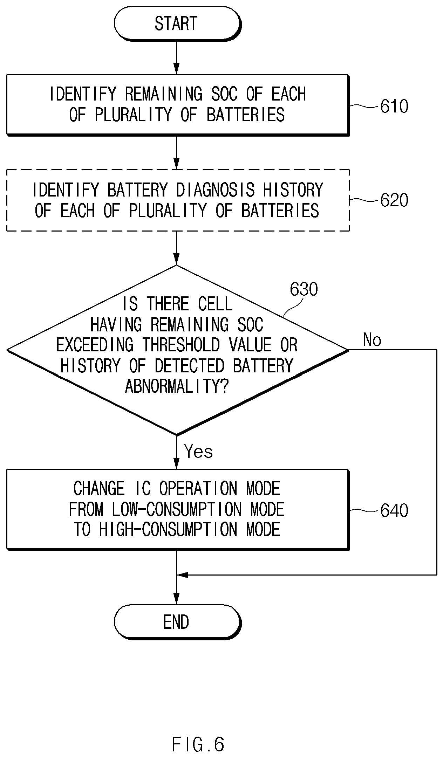

Referring to FIG. 6, operations 610 to 630 may be similar or identical to operations of FIG. 5 and thus will not be described below. When there is a battery having the remaining SoC exceeding the threshold value or having the history of detected battery abnormality in operation 630, the battery control system 1 may set the IC operation mode of the battery from the low consumption mode to the high consumption mode in operation 640.

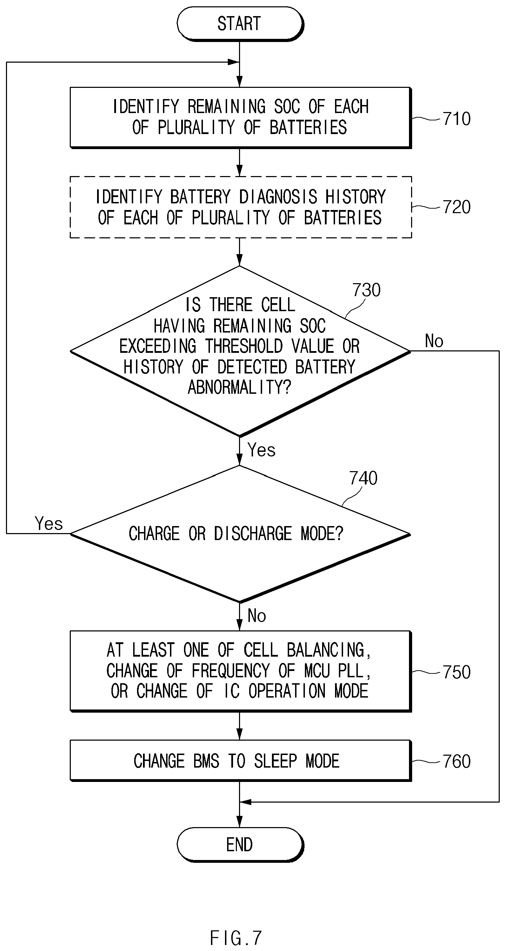

Referring to FIG. 7, operations 710 to 730 may be similar or identical to operations of FIG. 5 and thus will not be described below. When there is a battery having the remaining SoC exceeding the threshold value or having the history of detected battery abnormality in operation 730, the battery control system 1 may identify whether the battery control system 1 is in the charge or discharge mode in operation 740. When the battery control system 1 is in the charge or discharge mode, the battery control system 1 may wait for termination of the charge or discharge mode without performing operation 750 to prevent safety from being degraded due to forced reduction of the energy density. When the charge or discharge mode is terminated, the battery control system 1 may repeat operations 710 to 730 to reflect the SoC changed due to charge/discharge.

When the battery control system 1 is neither in the charge mode nor in the discharge mode, the battery control system 1 may perform at least one of cell balancing, change of the frequency of the MCU PLL, or change of the IC operation mode, as described above with reference to FIGS. 4 to 6, in operation 750.

In operation 760, the battery control system 1 may change the battery management system of the battery having the remaining SoC exceeding the threshold value or having the history of detected battery abnormality into the sleep mode, thereby preventing arbitrary use of the user.

FIG. 8 is a block diagram showing a computing system that performs a battery management method according to various embodiments.

Referring to FIG. 8, a computing system 30 according to an embodiment disclosed herein may include an MCU 32, a memory 34, an input/output I/F 36, and a communication I/F 38.

The MCU 32 may be a processor that executes various programs (e.g., a feature calculation program, a class classification and lifespan estimation program, etc.) stored in the memory 34, processes various data including voltage, current, etc., of a battery cell through these programs, and executes the above-described functions of the battery management apparatus shown in FIGS. 1 to 7.

The memory 34 may store various programs regarding feature calculation, class classification, and lifespan estimation of the battery cell. Moreover, the memory 34 may store various data such as a voltage, a current, feature data, etc., of each battery cell.

The memory 34 may be provided in plural, depending on a need. The memory 34 may be volatile memory or non-volatile memory. For the memory 34 as the volatile memory, random access memory (RAM), dynamic RAM (DRAM), static RAM (SRAM), etc., may be used. For the memory 34 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 34 are merely examples and are not limited thereto.

The input/output I/F 36 may provide an interface for transmitting and receiving data by connecting an input device (not shown) such as a keyboard, a mouse, a touch panel, etc., and an output device such as a display (not shown), etc., to the MCU 32.

The communication I/F 340, which is a component capable of transmitting and receiving various data to and from a server, may be various devices capable of supporting wired or wireless communication. For example, a program for feature calculation, class classification, and lifespan estimation for a battery cell or various data, etc., may be transmitted and received to and from a separately provided external server through the communication I/F 38.

As such, a computer program according to an embodiment disclosed herein may be recorded in the memory 34 and processed by the MCU 32, thus being implemented as a module that performs functions shown in FIG. 1 or 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure. Therefore, the embodiments disclosed herein are intended for description rather than limitation of the technical teaching of the embodiments disclosed herein and the scope of the technical teaching of the present disclosure is not limited by these embodiments disclosed herein. The protection scope of the technical teaching disclosed herein should be interpreted by the following claims.

## Claims

1. An operating method of a battery control system (1) comprising a plurality batteries (210-1 to 210-5), the operating method comprising:
identifying (710), by means of a master battery management system, BMS, (220), a remaining state of charge, SoC, of each of the plurality of batteries through a plurality of corresponding BMSs (#1, #2);
identifying (740) whether the battery control system (1) is in a charge mode or a discharge mode;
setting, when the battery control system (1) is in the charge mode or in the discharge mode, at least one battery management system corresponding to at least one battery having remaining SoC exceeding a threshold value to a sleep mode;
performing (750), when the battery control system is neither in the charge mode nor in the discharge mode, at least one of: cell balancing up to a designated level for the at least one battery having the remaining SoC exceeding the threshold value, or setting a frequency of a microcontroller unit, MCU, phase-locked loop, PLL, corresponding to each of the at least one battery having the remaining SoC exceeding the threshold value to a maximum value.

2. The operating method of claim 1, further comprising, when the battery control system is neither in the charge mode nor in the discharge mode, changing an operation mode of an integrated circuit, IC, corresponding to each of the at least one battery having the remaining SoC exceeding the threshold value from a low consumption mode to a high consumption mode.

3. The operating method of claim 1, further comprising:
identifying (720) a battery diagnosis history of each of the plurality of batteries; and
identifying (730) the at least one battery from the plurality of batteries based on whether the remaining SoC exceeds the threshold value or whether a history of detected battery abnormality exists.

4. A battery control system (1) comprising:
a plurality of batteries (210-1 to 210-5);
a plurality of battery management systems (#1, #2) configured to manage each of the plurality of batteries; and
a master battery management system (220),
wherein the master battery management system is configured to:
identify a remaining state of charge, SoC, of each of the plurality of batteries through the plurality of battery management systems;
identify whether the battery control system (1) is in a charge mode or a discharge mode;
set, when the battery control system (1) is in the charge mode or in the discharge mode, at least one battery management system corresponding to at least one battery having remaining SoC exceeding a threshold value to a sleep mode;
perform, when the battery control system is neither in the charge mode nor in the discharge mode, at least one of: cell balancing up to a designated level for the at least one battery having the remaining SoC exceeding the threshold value, or setting a frequency of a microcontroller unit, MCU, phase-locked loop, PLL, corresponding to each of the at least one battery having the remaining SoC exceeding the threshold value to a maximum value.

5. The battery control system of claim 4, wherein, when the battery control system is neither in the charge mode nor in the discharge mode, the master battery management system is further configured to change an operation mode of an integrated circuit (IC) corresponding to each of the at least one battery having the remaining SoC exceeding the threshold value from a low consumption mode to a high consumption mode.

6. The battery control system of claim 4, wherein the master battery management system is further configured to:
identify a battery diagnosis history of each of the plurality of batteries; and
identify the at least one battery from the plurality of batteries based on whether the remaining SoC exceeds the threshold value or whether a history of detected battery abnormality exists.

## Patentansprüche

1. Betriebsverfahren eines Batteriesteuerungssystems (1), umfassend eine Mehrzahl von Batterien (210-1 bis 210-5), wobei das Betriebsverfahren umfasst:
Identifizieren (710), mit Hilfe eines Master-Batterieverwaltungssystems, BMS, (220), eines verbleibenden Ladezustands, SOC, jeder der Mehrzahl von Batterien durch eine Mehrzahl von entsprechenden BMS (#1, #2);
Identifizieren (740), ob sich das Batteriesteuerungssystem (1) in einem Lademodus oder einem Entlademodus befindet;
Festlegen, wenn sich das Batteriesteuerungssystem (1) in dem Lademodus oder Entlademodus befindet, wenigstens eines Batterieverwaltungssystems, welches wenigstens einer Batterie entspricht, welche einen verbleibenden SOC aufweist, welcher einen Schwellenwert überschreitet, auf einen Schlafmodus;
Durchführen (750), wenn sich das Batteriesteuerungssystem weder in dem Lademodus noch in dem Entlademodus befindet, wenigstens eines aus:
Zellenausgleichen bis zu einem designierten Level für die wenigstens eine Batterie, welche den verbleibenden SOC aufweist, welcher den Schwellenwert überschreitet, oder Festlegen einer Frequenz eines Microsteuereinheit, MUC, Phasenregelkreises, PLL, welcher jeder der wenigstens einen Batterie entspricht, welche den verbleibenden SOC aufweist, welcher den Schwellenwert überschreitet, auf einen maximalen Wert.

2. Betriebsverfahren nach Anspruch 1, ferner umfassend, wenn sich das Batteriesteuerungssystem weder in dem Lademodus noch in dem Entlademodus befindet, Ändern eines Betriebsmodus einer integrierten Schaltung, IC, welche jeder der wenigstens einen Batterie entspricht, welche den verbleibenden SOC aufweist, welcher den Schwellenwert überschreitet, von einem niedrigen Verbrauchsmodus zu einem hohen Verbrauchsmodus.

3. Betriebsverfahren nach Anspruch 1, ferner umfassend:
Identifizieren (720) einer Batteriediagnostizierhistorie jeder der Mehrzahl von Batterien; und
Identifizieren (730) der wenigstens einen Batterie aus der Mehrzahl von Batterien, auf Grundlage dessen, ob der verbleibende SOC den Schwellenwert überschreitet oder ob eine Historie einer detektierten Batterieabnormalität existiert.

4. Batteriesteuerungssystem (1), umfassend:
eine Mehrzahl von Batterien (210-1 bis 210-5);
eine Mehrzahl von Batterieverwaltungssystemen (#1, #2), welche dazu eingerichtet sind, jede der Mehrzahl von Batterien zu verwalten; und
ein Master-Batterieverwaltungssystem (220),
wobei das Master-Batterieverwaltungssystem eingerichtet ist, zum:
Identifizieren eines verbleibenden Ladezustands, SOC, jeder der Mehrzahl von Batterien durch die Mehrzahl von Batterieverwaltungssystemen;
Identifizieren, ob sich das Batteriesteuerungssystem (1) in einem Lademodus oder einem Entlademodus befindet;
Festlegen, wenn sich das Batteriesteuerungssystem (1) in dem Lademodus oder Entlademodus befindet, wenigstens eines Batterieverwaltungssystems, welches wenigstens einer Batterie entspricht, welche einen verbleibenden SOC aufweist, welcher einen Schwellenwert überschreitet, auf einen Schlafmodus;
Durchführen, wenn sich das Batteriesteuerungssystem weder in dem Lademodus noch in dem Entlademodus befindet, wenigstens eines aus:
Zellenausgleichen bis zu einem designierten Level für die wenigstens eine Batterie, welche den verbleibenden SOC aufweist, welcher den Schwellenwert überschreitet, oder Festlegen einer Frequenz eines Microsteuereinheit, MUC, Phasenregelkreises, PLL, welcher jeder der wenigstens einer Batterie entspricht, welche den verbleibenden SOC aufweist, welcher den Schwellenwert überschreitet, auf einen maximalen Wert.

5. Batteriesteuerungssystem nach Anspruch 4, wobei, wenn sich das Batteriesteuerungssystem weder in dem Lademodus noch in dem Entlademodus befindet, das Master-Batterieverwaltungssystem ferner dazu eingerichtet ist, einen Betriebsmodus einer integrierten Schaltung, IC, welche jeder der wenigstens einen Batterie entspricht, welche den verbleibenden SOC aufweist, welcher den Schwellenwert überschreitet, von einem niedrigen Verbrauchsmodus zu einem hohen Verbrauchsmodus zu ändern.

6. Batteriesteuerungssystem nach Anspruch 4, wobei das Master-Batterieverwaltungssystem ferner eingerichtet ist, zum:
Identifizieren einer Batteriediagnostizierhistorie jeder der Mehrzahl von Batterien; und
Identifizieren der wenigstens einen Batterie aus der Mehrzahl von Batterien, auf Grundlage dessen, ob der verbleibende SOC den Schwellenwert überschreitet oder ob eine Historie einer detektierten Batterieabnormalität existiert.

## Revendications

1. Procédé de fonctionnement d'un système de commande de batteries (1) comprenant une pluralité de batteries (210-1 à 210-5), le procédé de fonctionnement comprenant :
l'identification (710), au moyen d'un système de gestion de batteries, BMS, maître (220) d'un état de charge, SoC, restant de chacune de la pluralité de batteries par le biais d'une pluralité de BMS (#1, #2) correspondants ;
le fait d'identifier (740) si le système de commande de batteries (1) est en mode charge ou en mode décharge ;
le réglage, lorsque le système de commande de batteries (1) est en mode charge ou en mode décharge, d'au moins un système de gestion de batterie correspondant à au moins une batterie ayant un SoC restant dépassant une valeur seuil en mode veille ;
la réalisation (750), lorsque le système de commande de batteries n'est ni en mode charge ni en mode décharge, d'au moins un parmi : l'équilibrage de cellule jusqu'à un niveau désigné pour l'au moins une batterie ayant le SoC restant dépassant la valeur seuil, ou le réglage d'une fréquence d'une boucle à verrouillage de phase, PLL, d'unité de microcontrôleur, MCU, correspondant à chacune des au moins une batterie ayant le SoC restant dépassant la valeur seuil sur une valeur maximale.

2. Procédé de fonctionnement selon la revendication 1, comprenant en outre, lorsque le système de commande de batteries n'est ni en mode charge ni en mode décharge, le passage d'un mode de fonctionnement d'un circuit intégré, IC, correspondant à chacune des au moins une batterie ayant le SoC restant dépassant la valeur seuil d'un mode à faible consommation à un mode à consommation élevée.

3. Procédé de fonctionnement selon la revendication 1, comprenant en outre :
l'identification (720) d'un historique de diagnostic de batterie de chacune de la pluralité de batteries ; et
l'identification (730) de l'au moins une batterie parmi la pluralité de batteries sur la base du fait que le SoC restant dépasse la valeur seuil ou qu'il existe un historique d'anomalie de batterie détectée.

4. Système de commande de batteries (1) comprenant :
une pluralité de batteries (210-1 à 210-5) ;
une pluralité de systèmes de gestion de batteries (#1, #2) configurés pour gérer chacune de la pluralité de batteries ; et
un système de gestion de batteries maître (220),
dans lequel le système de gestion de batteries maître est configuré pour :
identifier un état de charge, SoC, restant de chacune de la pluralité de batteries par le biais de la pluralité de systèmes de gestion de batteries ;
identifier si le système de commande de batteries (1) est en mode charge ou en mode décharge ;
régler, lorsque le système de commande de batteries (1) est en mode charge ou en mode décharge, au moins un système de gestion de batterie correspondant à au moins une batterie ayant un SoC restant dépassant une valeur seuil en mode veille ;
réaliser, lorsque le système de commande de batteries n'est ni en mode charge ni en mode décharge, au moins un parmi : l'équilibrage de cellule jusqu'à un niveau désigné pour l'au moins une batterie ayant le SoC restant dépassant la valeur seuil, ou le réglage d'une fréquence d'une boucle à verrouillage de phase, PLL, d'unité de microcontrôleur, MCU, correspondant à chacune des au moins une batterie ayant le SoC restant dépassant la valeur seuil sur une valeur maximale.

5. Système de commande de batteries selon la revendication 4, dans lequel, lorsque le système de commande de batteries n'est ni en mode charge ni en mode décharge, le système de gestion de batteries maître est en outre configuré pour faire passer un mode de fonctionnement d'un circuit intégré (IC) correspondant à chacune des au moins une batterie ayant le SoC restant dépassant la valeur seuil d'un mode à faible consommation à un mode à consommation élevée.

6. Système de commande de batteries selon la revendication 4, dans lequel le système de gestion de batteries maître est en outre configuré pour :
identifier un historique de diagnostic de batterie de chacune de la pluralité de batteries ; et
identifier l'au moins une batterie parmi la pluralité de batteries sur la base du fait que le SoC restant dépasse la valeur seuil ou qu'il existe un historique d'anomalie de batterie détectée.
